# EUROPEAN PATENT SPECIFICATION

(11) **EP 3 156 991 B1**
(45) Date of publication and mention of the grant of the patent: **04.11.2020**
(21) Application number: 16188050.5
(22) Date of filing: 09.09.2016
(51) Int. Cl.: G09F 9/302, G09F 9/33

(54) **OPTICAL ELEMENT OF LED DISPLAY APPARATUS AND LED DISPLAY APPARATUS**
OPTISCHES ELEMENT AUS LED-ANZEIGEVORRICHTUNG UND LED-ANZEIGEVORRICHTUNG
ÉLÉMENT OPTIQUE DE DISPOSITIF D'AFFICHAGE À DEL ET DISPOSITIF D'AFFICHAGE À DEL

(30) Priority: 12.10.2015 KR 20150142130
(43) Date of publication of application: 19.04.2017
(73) Proprietor: Samsung Electronics Co., Ltd., Suwon-si, Gyeonggi-do 16677 (KR)
(72) Inventor: HA, Tae-hyeun, Gyeonggi-do (KR); KIM, Jae-sang, Seoul (KR); NOH, Jae-heon, Gyeonggi-do (KR)
(74) Representative: Appleyard Lees IP LLP

(56) References cited:
- EP-A1- 2 717 244
- EP-A2- 1 645 800
- CA-A1- 2 903 265
- CN-A- 104 049 374
- CN-A- 104 680 947
- CN-U- 202 075 944
- US-A1- 2002 084 952

## Description

### BACKGROUND

### 1. Field

Apparatuses and methods consistent with exemplary embodiments relate to a light emitting diode (LED) display apparatus, and more specifically, to an optical element of an LED display apparatus capable of reducing Moire phenomenon and/or a blur phenomenon.

### 2. Description of the Related Art

An LED display apparatus has excellent brightness and color attributes, compared to other types of display apparatuses, e.g., an LCD display. As a result, an LED display apparatus is widely used in an indoor/outdoor billboard, an indoor/outdoor guide board, an electric sign of a sports stadium or an indoor/outdoor backdrop. A light emitting diode may be disposed in a matrix form of M*N (where M and N are natural numbers).

In general, a pitch between light emitting diodes arranged in a matrix form of an LED display apparatus is wider than other types of display apparatuses. As a result, when an LED display apparatus having a non-light emitting region (for example, a region between light emitting diodes) is captured using a camera, unwanted pattern, e.g., wave pattern or Moire pattern, may be generated. Further, a blur phenomenon may also occur. CN 104680947 A relates to a device for eliminating moire fringes. CN 202075944 U relates to a screen module with parallel grooves changing an emitting angle. US2002/0084952A1 describes a further example of the related art.

### SUMMARY

According to the present invention there is provided an apparatus as set forth in appended claim 1. Other features of the invention will be apparent from the dependent claims, and the description which follows.

According to an aspect of an exemplary embodiment, there may be provided a light emitting diode (LED) display apparatus including: an LED module including a plurality of LEDs mounted on a circuit board; and an optical film including a plurality of unit lenses configured to cover the LED module and transmit light emitted from the plurality of LEDs, wherein at least one of the plurality of unit lenses has a cross-lenticular lens shape or a cross-prismatic lens shape.

Each of the plurality of LEDs forms one sub-pixel, and a plurality of sub-pixels form one pixel of a screen of the LED display apparatus.

The one pixel may be formed using a red LED, a green LED, and a blue LED.

A cross-sectional shape of the plurality of unit lenses may include at least one of a triangle, a round, a triangle having round corners, and a polygonal having round corners.

At least two unit lenses from among the plurality of unit lenses may have a different size of a cross-sectional shape.

Multiple unit lenses overlap one sub-pixel.

A number of the unit lenses overlapping one sub-pixel may be equal to or greater than five.

A width of a unit lens may be in a range of 20 µm to 50 µm.

A raw material of the optical film may include at least one of acryl, polyethylene, polyethylene terephthalate (PET), resin, and silicone.

The optical film may be bonded to the LED module using an adhesive.

The optical film may further include a diffusing agent having a spherical shape.

The diffusing agent may have a porous surface.

A diameter of the diffusing agent may be smaller than a width of a unit lens of the optical film.

The apparatus may further include: an LED panel including a plurality of the LED modules arranged in a matrix form; and an LED cabinet configured to support the LED panel and transfer at least one of power and a driving signal to the LED panel.

According to another aspect of an exemplary embodiment, there may be provided a light emitting diode (LED) display apparatus including: a plurality of LED modules, each of which including a plurality of LEDs mounted on a circuit board in a matrix form; an LED panel on which the plurality of LED modules are arranged in a matrix form; and an optical film including a plurality of unit lenses configured to cover the plurality of LED modules and transmit light emitted from the plurality of LEDs, wherein at least one of the plurality of unit lenses has a cross-lenticular lens shape.

At least one of the plurality of unit lenses may have a cross-prismatic lens shape.

The apparatus may further include an LED cabinet configured to support the LED panel and transfer at least one of power and a driving signal to the plurality of LED modules.

At least one of the power and the driving signal may be provided from an external source to the LED display apparatus.

However, the example is not limited thereto. According to an exemplary embodiments, an optical element of an LED display apparatus may have a two-dimensional cross-lenticular lens shape to adjust light-transmissibility and/or light-diffusibility, thereby improving luminance, brightness, and/or a fill factor. According to various exemplary embodiments, an optical element of an LED display apparatus may have a two-dimensional cross-prismatic lens shape to adjust light-transmissibility and/or light-diffusibility, thereby improving luminance, brightness, and/or a fill factor.

### BRIEF DESCRIPTION OF THE DRAWINGS

The above and other aspects of one or more exemplary embodiments will become more apparent by reference to specific embodiments thereof which are illustrated in the appended drawings. These drawings depict only exemplary embodiments and are not therefore to be considered to be limiting the scope of the inventive concept.
FIG. 1 illustrates a schematic view illustrating an LED display apparatus, according to an exemplary embodiment;
FIG. 2A illustrates a schematic front perspective view illustrating an LED display apparatus, according to an exemplary embodiment;
FIG. 2B illustrates a schematic rear perspective view illustrating an LED display apparatus, according to an exemplary embodiment;
FIG. 3 illustrates a schematic exploded perspective view illustrating an LED display apparatus, according to an exemplary embodiment;
FIG. 4 illustrates a schematic cross-sectional view and a schematic perspective view illustrating an optical element of an LED display apparatus, according to an exemplary embodiment;
FIG. 5A illustrates a schematic view illustrating an optical element and LEDs, according to an exemplary embodiment;
FIG. 5B illustrates a schematic view illustrating an optical element and LEDs, according to another exemplary embodiment;
FIG. 5C illustrates a schematic view illustrating an optical element and LEDs, according to yet another exemplary embodiment;
FIG. 6A illustrates a schematic front perspective view illustrating an LED display apparatus, according to another exemplary embodiment; and
FIG. 6B illustrates a schematic rear perspective view illustrating an LED display apparatus, according to yet another exemplary embodiment;

### DETAILED DESCRIPTION OF EXEMPLARY EMBODIMENTS

Certain exemplary embodiments will now be described in greater detail with reference to the accompanying drawings. Further, a method for preparing and using the present disclosure will be described in greater detail with reference to the accompanying drawings. Like reference numbers refer to like parts, components, and structures.

Terms including an ordinal number, such as "first," "second," etc. may be used to explain various components, and the above-mentioned components are not limited to the above-mentioned terms. The above-mentioned terms may be used for the purpose of distinguishing one component from another. For example, a first component may be called a second component within the scope of rights of the present disclosure. Further, the second component may be called the first component.

The term "and/or" may include a combination of a plurality of recited items that are related to each other or any one of a plurality of recited items that are related to each other. Further, "film," "sheet" or "plate" only differ in names, and may not be distinguished from one another.

Content may be displayed in a display apparatus. Content may be received in a control apparatus and/or a display apparatus. For example, content may include a video file reproduced in a video player, which is one of applications, or an audio file, a music file reproduced in a music player, a photo file displayed in a photo gallery, a webpage file displayed in a web browser, a text file, or etc. Further, content may include broadcast being received.

Terms used in the present disclosure are used to describe exemplary embodiments, and are not intended to limit and/or restrict the present disclosure. A singular term includes a plural form unless it is intentionally written that way.

The terms, "include," "have" etc. of the description are used to indicate the existence of features, numbers, steps, operations, elements, parts or combination thereof, and do not exclude the possibilities of combination or addition of one or more features, numbers, steps, operations, elements, parts or combination thereof. Like reference numbers refer to members that perform substantially the same function.

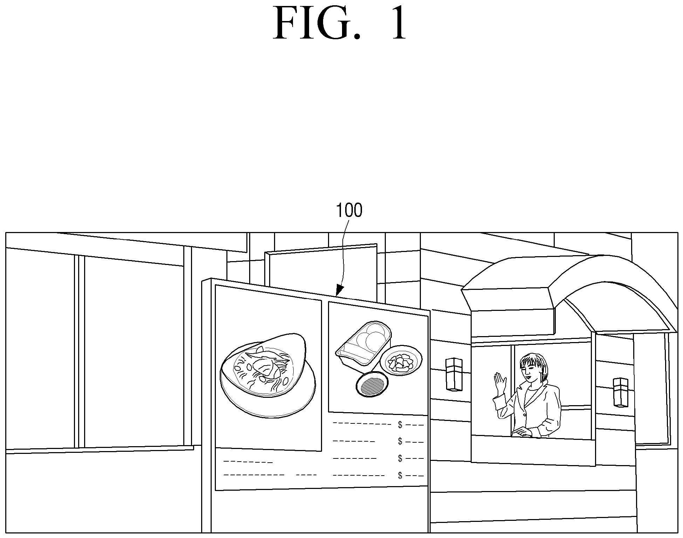

FIG. 1 is a schematic view illustrating an LED display apparatus, according to an exemplary embodiment. FIG. 1 shows that an LED display apparatus 100 is installed outdoors, but it would be readily understood by one of ordinary skill in the art that the LED display apparatus may be installed indoors according to another exemplary embodiment.

Referring to FIG. 1, the LED display apparatus 100 may be implemented as a billboard at a store, which displays merchants and/or price to provide information to customers.

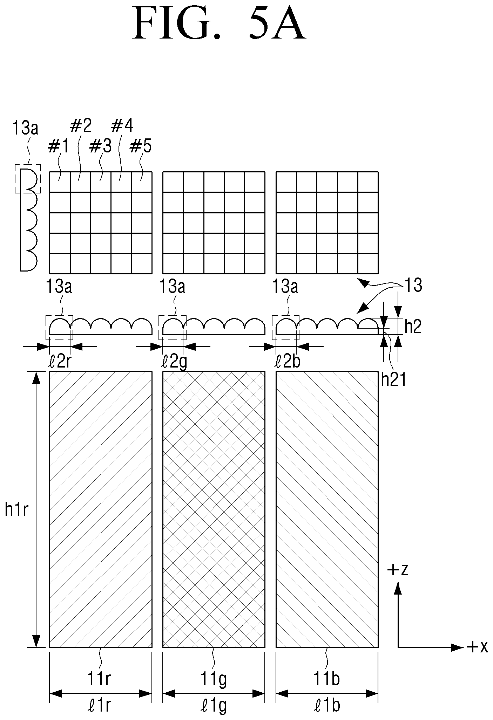

The LED display apparatus 100 may include LEDs respectively emitting a red light, a green light and/or a blue light in a matrix form. Further, referring to FIG. 5A, the LED display apparatus 100 may package a red LED 11r, a green LED 11g and a blue LED 11b to form one pixel, and arrange them in a matrix form. Each of the LEDs, i.e., a red LED 11r, a green LED 11g and a blue LED 11b may be called a sub-pixel. Further, the LED display apparatus 100 may include an LED to emit a white color light and a color filter to extract various colors from the white color light.

The LED display apparatus 100 may include a screen formed by a plurality of LEDs. The LED display apparatus 100 may display content by driving a plurality of LEDs.

The LED display apparatus may provide a user with a good visibility due to its high brightness (for example, 2,500 nit). Further, the LED display apparatus 100 may have a waterproof and/or vibration-proof feature. The waterproof and/or vibration-proof feature may be determined with reference to an Ingress Protection rating.

The LED display apparatus 100 may be fixed to a wall by a wall mount unit or by a stand, depending on a distance between provided information (for example, advertisement) and the user and/or an eye level of the user.

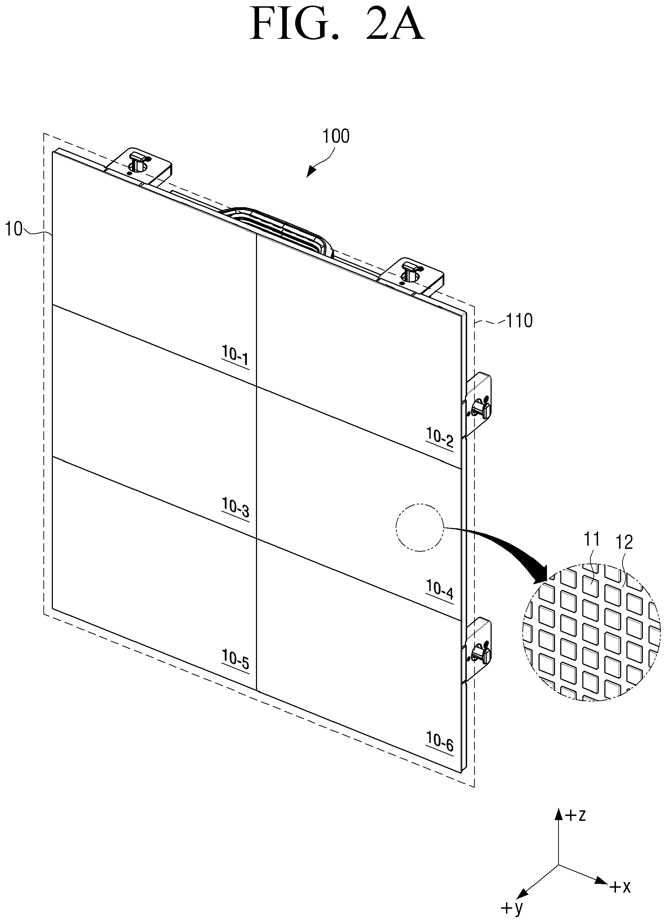

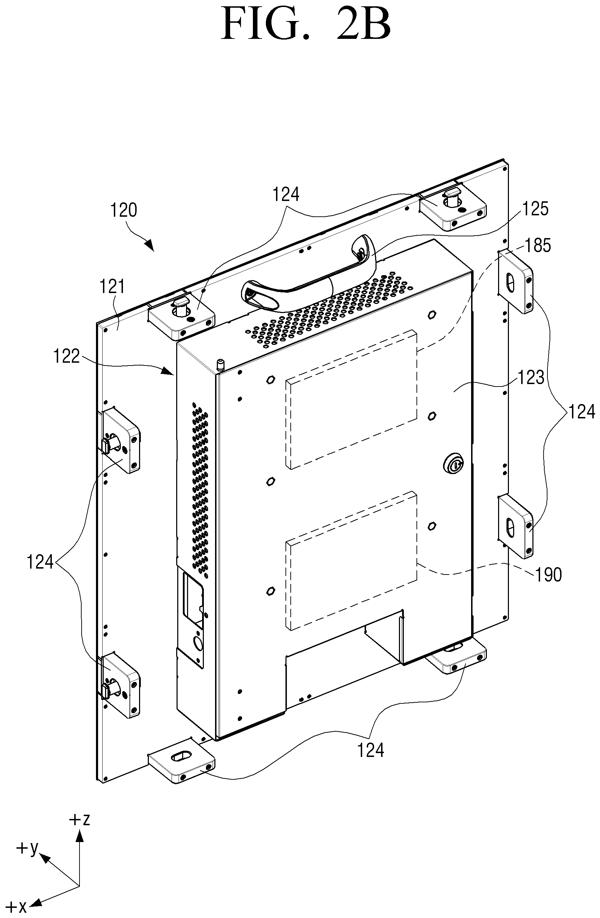

The LED display apparatus 100 may include a plurality of LEDs 11 (see FIG. 2A), a plurality of LED modules 10 (see FIG. 2A) which display content using the plurality of LEDs 11, and/or an LED cabinet 120 (see FIG. 2B) which supports the plurality of LED modules 10. The LED cabinet 120 may transfer power and/or a driving signal to the LED modules 10 and/or the LEDs 11. One LED module 10 or a plurality of LED modules 10 may be referred to as an LED panel 110.

Although an LED display apparatus 100 including 2*3 LED modules 10 is illustrated in FIG. 2A, it will be easily understood by one of ordinary skill in the art that the number and dispositional pattern of the LED modules 10 may be modified in various ways.

The LED display apparatus 100 and components of the LED display apparatus 100 will be described in greater detail below.

The LED display apparatus 100 may be implemented as a curved LED display apparatus having various curvatures. For example, the LED display apparatus 100 may have a screen having a fixed (or one) curvature (e.g., 2500R), a plurality of curvatures (e.g., A first curvature of 2500R and a second curvature of 3000R). The LED display apparatus 100 may also be a curvature variable type LED display apparatus in which a curvature of a current screen changes according to a user input. However, it would be easily understood by those skilled in the art that examples of the LED display apparatus 100 are not limited thereto.

An external control device may be connected to one side of the LED display apparatus 100. Alternatively, the LED display apparatus 100 may be connected to the control device through a communicator wirelessly.

In the case where the control device and the LED display apparatus 100 are connected to each other via cable and are respectively fixed to a wall by a wall mount unit, the control device may be positioned on the rear side of the LED display apparatus 100.

It will be easily understood by one of ordinary skill in the art that a size and/or shape of components included in the LED display apparatus 100 is modifiable.

FIGS. 2A and 2B illustrate respectively a front perspective view and a rear perspective view of an LED display apparatus according to an exemplary embodiment.

Referring to FIGS. 2A and 2B, the LED display apparatus 100 may include a plurality of LEDs 11, an LED module 10 including a circuit board 12 on which the plurality of LEDs 11 are mounted in a matrix form, an LED panel 110 including one or more LED modules, and an LED cabinet 120 which supports one or more LED panels 110.

Referring to FIG. 5A, the LED 11 may be implemented using a red LED 11r, a green LED 11g, and a blue LED 11b. As aforementioned, each of the red LED 11r, the green LED 11g, and the blue LED 11b may be referred to as a sub-pixel. The red LED 11r, the green LED 11g and the blue LED 11b, i.e., the sub-pixels, may form a single pixel and may be arranged repetitively. For example, the red LED 11r, i.e., a sub-pixel, may be arranged along a line in the direction of gravity. The green LED 11g, i.e., a sub-pixel, may be arranged on the right side of the red LED 11r along a line in the direction of gravity. Further, the blue LED 11b, i.e., a sub-pixel, may be arranged on the right side of the green LED 11g along a line in the direction of gravity.

The plurality of LEDs 11 may be mounted on the circuit board 12 in a matrix form (for example, M*N, in which M and N are natural numbers). The size of arrays in the matrix may be the same (e.g., 16*16, 24*24, 32*32, or 64*64 array) or different from each other.

The shape the circuit board 12 may vary according to exemplary embodiments. Examples of the shape of the circuit board 12 may include, but are not limited to, a triangle, a rectangle, and a polygon. To correspond to the circuit board 12, the LED module 10 may be triangular, quadrilateral or polygonal.

It will be easily understood by one of ordinary skill in the art that a pitch between a plurality of LEDs 11 of the LED module 10 may be arranged in various ways to correspond to a resolution and/or size of the LED display apparatus 100.

A red LED, a green LED and a blue LED may implement one pixel. The LED 11 may be driven (e.g., turned on, turned off, or flickered) by a driving signal transmitted from a timing controller 185.

The LED panel 110 may be a group of the LED modules 10-1 to 10-6 arranged in a matrix form. The LED panel 110 may be triangular, quadrilateral (e.g., rectangle or square) or polygonal depending on the shape of one LED module 10 or the shape of a plurality of LED modules 10 arranged in a matrix form.

A rear surface (e.g., opposite direction to light emission of LED) of the LED panel (or LED module) may be supported to intersect a direction of gravity (for example, -z direction) or may be supported in the direction of gravity by a front bracket 121 of the LED cabinet 120. The rear surface of the LED panel (or LED module) may be supported by a coupling member (e.g., bolt, rivet or magnet) of the front bracket 121 of the LED cabinet 120.

The LED cabinet 120 may include the front bracket 121, a frame bracket 122, and a cover 123. The LED cabinet 120 may include a link bracket 124. Further, the LED cabinet 120 may include a handle 125.

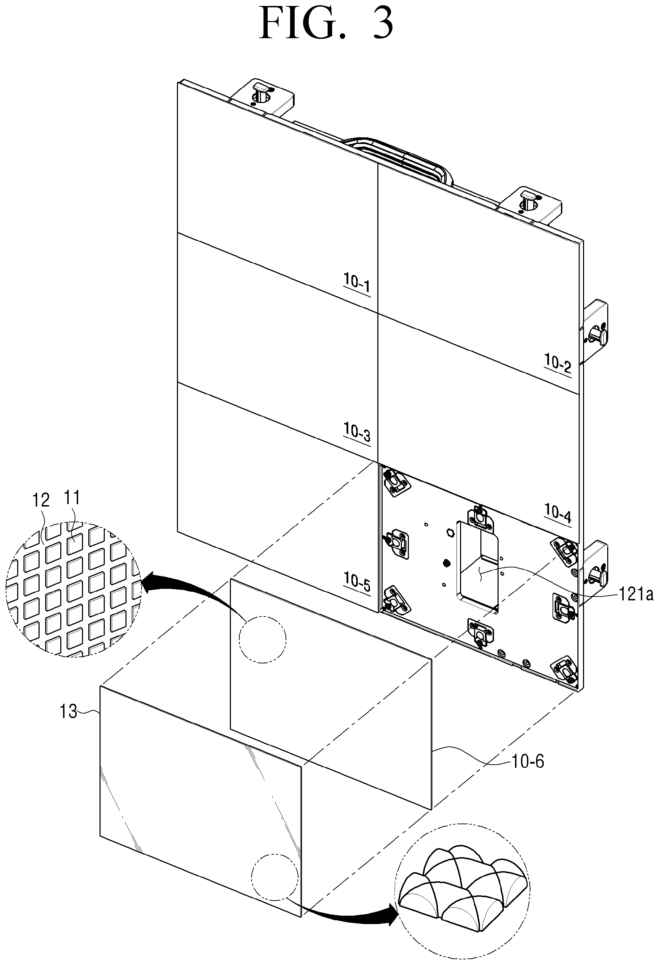

The front bracket 121 may support an LED panel (or LED module) and have an opening 121a (see FIG. 3). Through the opening 121a, a driving signal and/or power may be delivered to the LED panel (and/or LED module). An area of a base plate 121 may be larger than or equal to that of one or more LED modules 10. Further, if the LED display apparatus 100 is implemented as one LED panel 110, an area of the base plate 121 may be larger than or equal to that of the one LED panel 110.

The frame bracket 122 may hold some of components of the LED display apparatus 100 in a rear surface (e.g., -y axis direction) of the front bracket 121. The frame bracket 122 may hold one of the timing controller 185 which provides a driving signal that controls the LED 11 and a power supply unit 190 which supplies power to the LED panel 110 or both. Further, the frame bracket 122 may hold a main board which controls the timing controller 185 and the power supply unit 190.

The timing controller 185 may transmit a control signal for driving LED to the LED 11 according to a video (or image) received from the control device 100. The timing controller 185 may be connected to an external control device through an opening of the frame bracket 122 via cable.

The cover 123 may open or close a rear surface of the frame bracket 122.

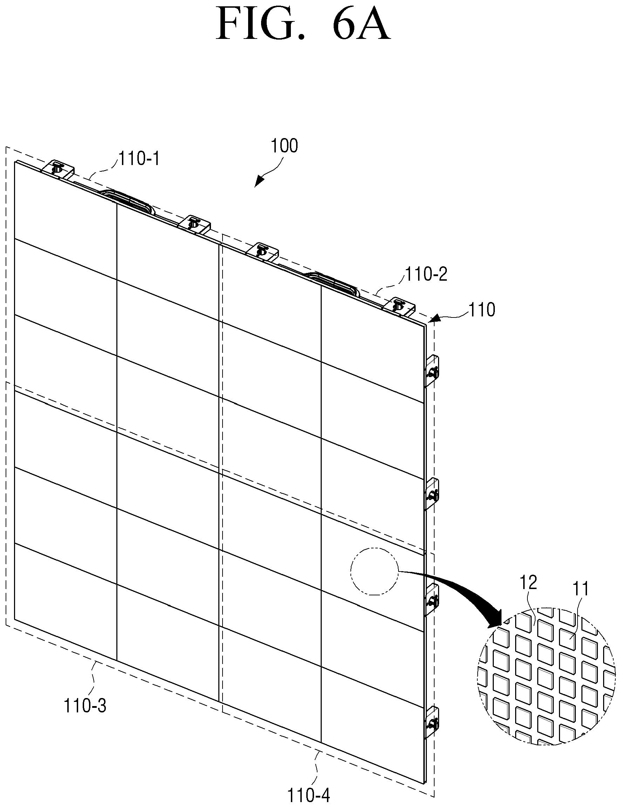

The link bracket 124 may connect the LED cabinet 120 with another LED cabinet (e.g., 110-1 to 110-4) (see FIG. 6A) positioned on one side (for example, upper, lower, left or right) of the LED cabinet 120 with a coupling member (e.g., bolt, rivet, or etc.).

The handle 125 may be used to move the LED cabinet 120.

The LED display apparatus 100 may include a plurality of LED panels 110 disposed in a matrix form and a plurality of LED cabinets 120 corresponding to the plurality of LED panels 110. The number of the LED panels 110 and the LED cabinets 120 may vary according to exemplary embodiments. For example, the LED display apparatus 100 may include one LED panel 110 and one LED cabinet 120.

FIG. 3 illustrates a exploded perspective view of an LED display apparatus, according to an exemplary embodiment.

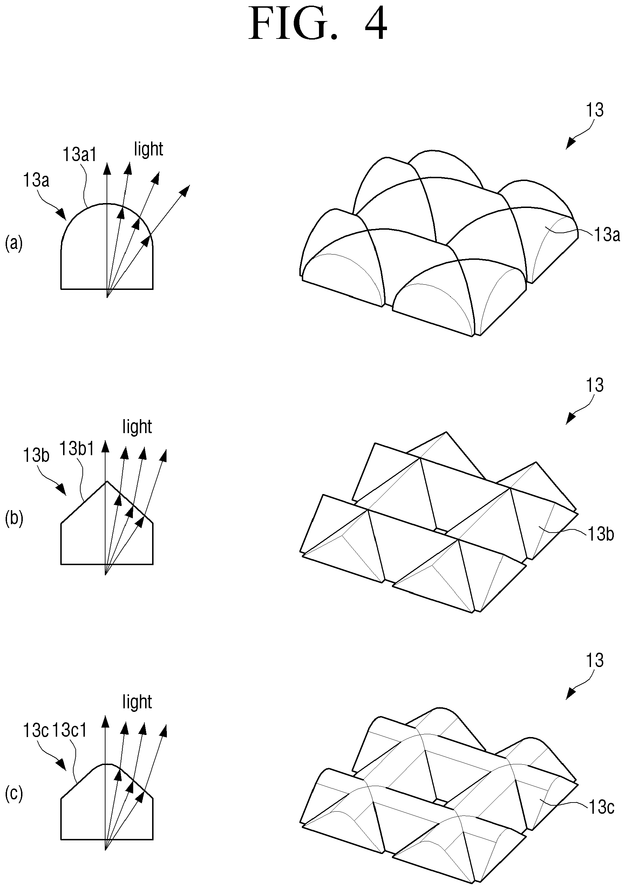

FIG. 4 illustrates a cross-sectional view and a perspective view of an optical element of an LED display apparatus according to an exemplary embodiment.

Referring to FIG. 3, an optical element 13 may be bonded with an LED module (e.g., 10-6) including LED 11 and a circuit board 12 to prevent a Moire phenomenon. The optical element 13 may transmit light emitted from the LED. Further, the optical element 13 may change a proceeding direction of light emitted from the LED (e.g., by refraction or reflection).

The optical element 13 may, for example, include a cross-lenticular lens film or a cross-prismatic lens film. In other words, the optical element 13 may, for example, include a cross-lenticular lens and/or a cross-prismatic lens. A user may view content displayed through an LED module (or LED panel) through the optical element 13. The term "optical element" may be interchangeable with "optical film."

The optical element 13 may be a cross-lenticular lens film or a cross-prismatic lens film having a lens shape or lens function with respect to two directions (e.g., two dimensions) of a transverse direction and a longitudinal direction.

Referring to Fig. 4, a cross-section of the optical element 13 may be round (a), triangular (b), or triangular with round corners (c). A cross-section of the optical element may be polygonal, e.g., pentagonal. Further, a cross-section of the optical element may be in the shape of a polygon having round corners. For example, an optical element of which a cross-section is round may be considered as a cross-lenticular lens film. Further, an optical element of which a cross-section is triangle (or in the shape of a polygon/ polygon with round corners) may be considered as a cross-prismatic lens film.

A fill factor may be improved by a cross-sectional shape of the optical element 13. With an improved fill factor, light may be provided to a light distribution reduction area created by a pitch between a plurality of LEDs 11. As such, the provided light may reduce a Moire phenomenon. Further, an improved fill factor may provide a light to a light distribution reduction area created by a pitch between a plurality of LEDs 11. Moreover, the provided light may reduce a blur phenomenon.

The optical element 13 may increase luminance indicating a brightness per unit area of the LED 11. Compared to an LED module 10 having no optical element 13, an LED module 10 with the optical element 13 may increase a luminance by 16%. For example, the increased luminance may be in the range of 10% and 18%. For another example, the increased luminance may be in the range of 15 % and 25 %.

The optical element 13 may improve a contrast ratio which indicates a difference between the brightest part and the darkest part in the LED module 10. The measured contrast ratio may be larger than or equal to 7900:1. For example, the contrast ratio may be in the range of 7500:1 to 8000:1. For another example, the contrast ratio may be in the range of 7,700:1 to 8,500:1.

A material of the optical element may include, but is not limited to, acrylic, polyethylene terephthalate (PET), resin, silicone or a material highly transmittable and transparent.

The optical element 13 may be positioned to come in contact with the LED 11 of the LED module 10. The optical element 13 may be positioned to come in contact with the LED 11 of the LED module 10 using various bonding methods (for example, adhesive, etc.). The optical element 13 and the LED 11 may be tightly fixed to each other, or may be fixed such that they almost come in contact with each other. Some bonding methods may be used to allow the optical element 13 and the LED 11 to be attached and detached from each other a number of times.

According to an exemplary embodiment, additional optical element may be positioned between the optical element 13 and the LED 11. Further, a plurality of additional optical elements may be positioned between the optical element 13 and the LED 11. Examples of the additional optical element may include, but are not limited to, a polarizing plate, an electromagnetic field blocking member, a protective film, an antireflective film.

Referring to FIG. 4, an optical element 13 may be a group of a plurality of unit lenses 13a, 13b or 13c which are repeatedly arranged in two dimensions. Light emitted from the LED 11 may be radiated through a light emitting surface 13a1, 13b1 and 13c1 of the unit lenses 13a, 13b and 13c. Light emitted from the LED 11 may be diffused through a light emitting surface 13a1, 13b1 and 13c1 of the unit lenses 13a, 13b and 13c. The light emitting surfaces 13a1, 13b1 and 13c1 of the unit lenses 13a, 13b and 13c may be flat or curved.

The diffusibility of light diffused through the light emitting surface 13a1, 13b1 and 13c1 of the unit lenses 13a, 13b and 13c may depend on an angle (e.g., angle between an optical axis and a light emitting surface, θ) and/or a curvature of the light emitting surface 13a1, 13b1 and 13c1.

Light diffused through the unit lenses 13a, 13b and 13c may have a virtual effect of reducing a pitch between the LED 11, thereby restricting an occurrence a Moire phenomenon and/or a blur phenomenon.

To limit a Moire phenomenon and/or a blur phenomenon, a diffusing agent may be added to the optical element 13. A diffusing agent may have a spherical shape or a polygonal shape. A diffusing agent may be in the shape of a sphere having a porous surface.

A diameter of a diffusing agent that has a spherical shape (with or without a porous surface) may be less than a diameter of a unit lens. For example, a diameter of a diffusing agent may be in the range of 0.1 µm to 10 µm. Further, a diameter of a diffusing agent may be in the range of 0.01 µm to 10 µm.

A diffusing agent may be added to the optical element 13 and may be penetrated by light emitted from the LED 11 with a high penetration rate and diffuse the light such that the LED 11 is not visible with a naked eye.

An inorganic material or an organic material which differs in refractive index by 0.02 to 0.13 in comparison with the optical element 13 may be used for the diffusing agent. An inorganic diffusing agent may include, but is not limited to, calcium carbonate, barium sulfate, titanium dioxide, aluminum hydroxide, silica, glass, talc, mica, white carbon, oxide of magnesium, zinc oxide, and/or a combination thereof. An organic diffusing agent may include, but is not limited to, acrylic cross-linked particle, siloxane-based cross-linked particle, and/or a combination thereof.

A unit lens 13a, 13b and 13c may be implemented on one surface of the optical element 13. Further, a unit lens 13a, 13b and 13c may be implemented on one surface (e.g., a light emitting side) of the optical element 13.

A height h21 (see FIG. 5A) of a unit lens 13a, 13b and 13c of the optical element 13 may be lower than a height h2 (see FIG. 5A) of the optical element 13. For example, the height h21 of the unit lens 13a, 13b and 13c of the optical element 13 may be in the range of 10% to 95% of the height h2 of the optical element 13.

FIG. 5A illustrates a schematic view illustrating an optical element and an LED, according to an exemplary embodiment.

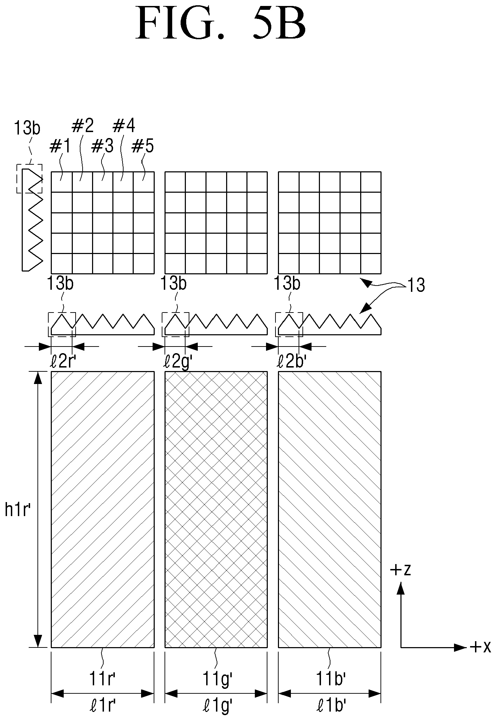

FIG. 5B illustrates a schematic view illustrating an optical element and an LED, according to another exemplary embodiment.

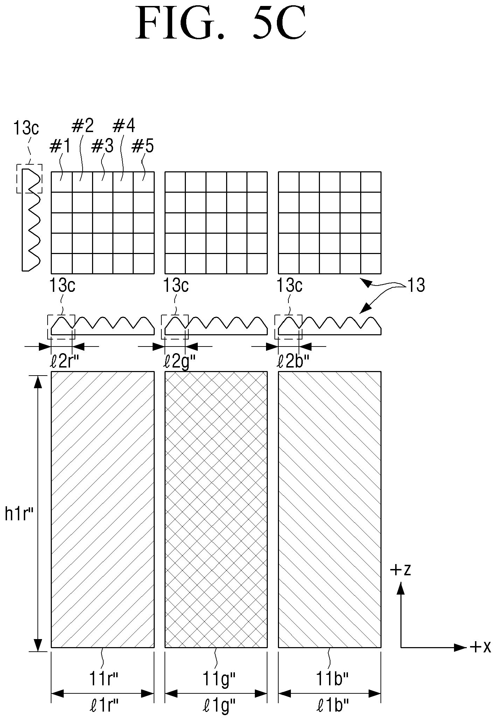

FIG. 5C illustrates a schematic view illustrating an optical element and an LED, according to yet another exemplary embodiment.

Referring to FIG. 5A, an LED, i.e., a full pixel, may be implemented with a plurality of sub-pixels, e.g., a red LED 11r, a green LED 11g, and a blue LED 11b.

An optical element 13 may correspond to each of the red LED 11r, the green LED 11g and the blue LED 11b, i.e., sub-pixels. The red LED 11r, the green LED 11g and the blue LED 11b, i.e., sub-pixels, may be positioned to correspond to a round-shaped unit lens 13a repetitively formed on the optical element 13.

A plurality of unit lenses 13a may correspond to one sub-pixel 11r (e.g., red LED). Hereinafter, a red LED will be described as an example, and features applicable to the red LED 11r may be applied to other sub-pixels as well.

A width I1r (e.g., +x axis direction) of the red LED 11r, which is one of sub-pixels of a full pixel, LED 11, may, for example, be 300 µm. The above-described width of a sub-pixel is described as an example, but it would be easily understood by those skilled in the art that the example is not limited thereto.

A width I2r (or pitch) of a unit lens 13a corresponding to a width I1r of the red LED 11r of the optical element 13 may vary according to exemplary embodiments. For example, the width I2r may be less than or equal to 1/6 of the width I1r of the red LED 11r. For another example, the width I2r of the unit lens 13a may be less than or equal to one 1/5 of a width I1r of the red LED 11r. As a result, for example, a width I2r of a unit lens 13a may be in the range of 20 µm to 50 µm. For another example, the width I2r of a unit lens 13a may be in the range of 11 µm to 40 µm. For another example, the width I2r of a unit lens 13a may be in the range of 30 µm to 60 µm.

A width I1g of a green LED 11g, which is one of sub-pixels of the LED, may, for example, be 300 µm. A width I2g of a unit lens 13a corresponding to a width I1g of the green LED 11g of the optical element 13 may vary according to exemplary embodiments. For example, a width I2g may be less than or equal to 1/6 of the width I1g of the green LED 11g. For another example, a width I2g of a unit lens 13a may be less than or equal to one fifth of a width I1g of a green LED 11g. As a result, for example, a width I2g of a unit lens 13a may be in the range of 20 µm to 50 µm. For another example, a width I2g of a unit lens 13a may be in the range of 11 µm to 40 µm. For another example, a width I2g of a unit lens 13a may be in the range of 30 µm to 60 µm.

A width I1b of the blue LED 11b, which is one of sub-pixels of a full pixel, LED 11, may, for example, be 300 µm. A width I2r of a unit lens 13a corresponding to a width I1b of the blue LED 11b may vary according to exemplary embodiments. For example, the width I2b may be less than or equal to 1/6 of the width I1b of the blue LED 11b. For another example, the width I2b of the unit lens 13a may be less than or equal to one fifth of a width I1b of the blue LED 11b. As a result, for example, the width I2b of a unit lens 13a may be in the range of 20 µm to 50 µm. For another example, the width I2b of a unit lens 13a may be in the range of 11 µm to 40 µm. For another example, the width I2b of a unit lens 13a may be in the range of 30 µm to 60 µm.

A unit lens 13a of the optical element 13 may be repetitively formed to correspond to a dimension (for example, width X length (height)) of an LED module 10.

A pitch between unit lenses 13a of the optical element 13 may be formed to correspond to a pitch between the sub-pixels, i.e., the red LED 11r, the green LED 11g, and the blue LED. For example, a pitch between a plurality of unit lenses corresponding to the red LED 11r and a plurality of unit lenses corresponding to the green LED 11g may be formed to correspond to a pitch between the red LED 11r and the green LED 11g. Likewise, a pitch between a plurality of unit lenses corresponding to the green LED 11g and a plurality of unit lenses corresponding to the blue LED 11b may be formed to correspond to a pitch between the green LED 11g and the blue LED 11b. Also, a pitch between a plurality of unit lenses corresponding to the blue LED 11b and a plurality of unit lenses corresponding to the red LED 11r may be formed to correspond to a pitch between the blue LED 11b and the red LED 11r.

According to another exemplary embodiment, a pitch between unit lenses 13a of the optical element may be formed to correspond to a pitch between an LED 11, which is a full pixel, and another adjacent LED. For example, a pitch between a plurality of unit lenses corresponding to one LED 11 and a plurality of unit lenses corresponding to the next LED may be formed to correspond to a pitch between one LED 11 and a next LED positioned in a traverse direction (e.g., +x axis direction). Likewise, a pitch between a plurality of unit lenses corresponding to one LED 11 and a plurality of unit lenses corresponding to the next LED may be formed to correspond to a pitch between one LED 11 and a next LED positioned in a longitudinal direction (e.g., +/-z axis direction).

According to another exemplary embodiment, a dimension (e.g., height, width or area) of a unit lens 13a of the optical element 13 may be formed differently according to a pitch between the red LED 11r, the green LED 11g and the blue LED 11b, i.e., sub-pixels.

In the case where the number of unit lenses 13a corresponding to one red LED 11r is five (i.e., odd number), a dimension (e.g., height, width or area) of the unit lens 13a may be different according to positions. For example, a dimension of unit lenses #1 and #5 positioned at the edges of the five unit lenses may be larger than a dimension of a unit lens #3 positioned in the center. Also, a dimension of unit lenses #1 and #5 positioned at the edges of the five unit lenses may be larger than dimensions of adjacent unit lenses #2 and #4. Further, dimensions of a plurality of unit lenses #2, #3 and #4 from among the five unit lenses may be the same.

In the case where the number of unit lenses 13a corresponding to a red LED 11r is six (i.e., even number), a dimension (e.g., height, width or area) of the unit lens 13a may be different according to positions. For example, a dimension of unit lenses #1 and #6 positioned at the edges of the six unit lenses may be larger than dimensions of unit lenses #3 and #4 positioned in the center. Dimensions of a plurality of unit lenses #2, #3, #4 and #5 from among the six unit lenses may be the same.

In the case where a plurality of unit lenses 13a correspond to one sub pixel 11r (e.g., red LED), a color split, which occurs when only one unit lens 13a corresponds to one sub-pixel 11r, may be reduced.

A height (i.e., a length on the z axis) of the red LED 11r, which is one of sub-pixels of a full pixel, LED 11, may, for example, be 1,000 µmµm. The above-described height of a sub-pixel is described as an example, but it would be easily understood by those skilled in the art that the example is not limited thereto.

A width I2r (or pitch) of a unit lens 13a may be determined depending on a height h1r of the red LED 11r of the optical element 13. For example, the width I2r may be less than or equal to one eighteenth of the height h1r of the red LED 11r. For another example, the width I2r of the unit lens 13a may be less than or equal to one fifteenth of a height h1r of the red LED 11r. As a result, for example, the width I2r may be in the range of 20 µm to 50 µm. For another example, the width I2r of a unit lens 13a may be in the range of 11 µm to 40 µm. For another example, the width I2r of a unit lens 13a may be in the range of 30 µm to 60 µm.

A unit lens 13a of the optical element 13 may be repetitively formed based on a dimension (for example, width X length (height)) of an LED module 10.

A pitch between unit lenses 13a of the optical element 13 may be formed to correspond to a pitch between the sub-pixels, e.g., between a red LED 11r and another red LED in an adjacent direction (e.g., +/- z axis direction). For example, a pitch between a plurality of unit lenses corresponding to the red LED 11r and a plurality of unit lenses corresponding to another adjacent red LED may be formed to correspond to a pitch between the red LED 11r and the another red Led positioned in a +z axis direction. For another example, a pitch between a plurality of unit lenses corresponding to the red LED 11r and a plurality of unit lenses corresponding to another adjacent red LED may be formed to correspond to a pitch between the red LED 11r and the another red Led positioned in a -z axis direction.

The above-described dispositions of unit lenses 13a are described taking an example of a width direction (e.g., x axis direction). However, it would be easily understood by one of ordinary skill in the art that the same may apply to a height direction (e.g., z axis direction) of the LED 11.

Referring to FIG. 5B, an LED 11, i.e., a full pixel, may be implemented with a plurality of sub-pixels, e.g., a red LED 11r', a green LED 11g', and a blue LED 11b'.

An optical element 13 may correspond to each of the red LED 11r', the green LED 11g' and the blue LED 11b', i.e., sub-pixels, may be implemented. The red LED 11r', the green LED 11g' and the blue LED 11b', i.e., sub-pixels, may be positioned to correspond to a round-shaped unit lens 13b repetitively formed on the optical element 13.

A plurality of unit lenses 13b may correspond to one sub-pixel 11r' (e.g., red LED). A plurality of unit lenses 13b may correspond to a red LED 11r' (which is described as an example, and the same applies to other sub-pixels as well), which is one sub-pixel.

A width I1r' of a red LED 11r' may be, for example, 300 µm. A width I2r' (or pitch) of a triangle-shaped unit lens 13b may vary according to exemplary embodiments. For example, the width I2r' may be less than or equal to 1/6 of the width I1r' of the red LED 11r'. For another example, the width I2r' of the unit lens 13b may be less than or equal to 1/5 of the width 11r' of the red LED 11r'. As a result, for example, the width I2r' of a unit lens 13b may be in the range of 20 µm to 50 µm.

A width I1g' of a green LED 11g' may be, as a non-limiting example, 300 µm. A width I2g' of a unit lens 13b may vary according to exemplary embodiments. For example, the width I2g' may be less than or equal to 1/6 of the width I1g' of the green LED 11g'. For another example, the width I2g' of a unit lens 13b may be less than or equal to 1/5 of the width I1g' of the green LED 11g'. As a result, for example, the width I2g' of a unit lens 13b may be in the range of 20 µm to 50 µm.

A width I1b' of a blue LED 11b' may be, as a non-limiting example, 300 µm. A width I2b' of a unit lens 13b corresponding to a width I1b' of a blue LED I1b' may vary according to exemplary embodiments. For example, the width I2b' may be less than or equal to 1/6 of the width I1b' of the blue LED 11b'. For another example, the width I2b' of the unit lens 13b may be less than or equal to 1/5 of a width I1b' of the blue LED 11b'. As a result, for example, the width I2b' of the unit lens 13b may be in the range of 20 µm to 50 µm.

A unit lens 13b of the optical element 13 may be repetitively formed to correspond to a dimension (e.g., width X length (height)) of an LED module 10.

A pitch between unit lenses 13b of the optical element 13 may be formed to correspond to a pitch between the sub-pixels, i.e., the red LED 11r', the green LED 11g', and the blue LED 11b'. For example, a pitch between a plurality of triangle-shaped unit lenses corresponding to the red LED 11r' and a plurality of triangle-shaped unit lenses corresponding to the green LED 11g' may be formed to correspond to a pitch between the red LED 11r' and the green LED 11g'. Likewise, a pitch between a plurality of triangle-shaped unit lenses corresponding to the green LED 11g' and a plurality of triangle-shaped unit lenses corresponding to the blue LED 11b' may be formed to correspond to a pitch between the green LED 11g' and the blue LED 11b'. Also, a pitch between a plurality of triangle-shaped unit lenses corresponding to the blue LED 11b' and a plurality of triangle-shaped unit lenses corresponding to the red LED 11r' may be formed to correspond to a pitch between the blue LED 11b' and the red LED 11r'.

According to another exemplary embodiment, a pitch between unit lenses 13b of the optical element 13 may be formed to correspond to a pitch between an LED 11, which is a full pixel, and another adjacent LED. For example, a pitch between a plurality of unit lenses corresponding to one LED 11 and a plurality of unit lenses corresponding to the next LED may be formed to correspond to a pitch between one LED 11 and a next LED positioned in a traverse direction (e.g., x-axis direction). Likewise, a pitch between a plurality of unit lenses corresponding to one LED 11 and a plurality of unit lenses corresponding to the next LED may be formed to correspond to a pitch between one LED 11 and a next LED positioned in a longitudinal direction (e.g., z axis direction).

According to another exemplary embodiment, a dimension (e.g., height, width or area) of a unit lens 13a of the optical element 13 may be formed differently according to a pitch between the red LED 11r', the green LED 11g' and the blue LED 11b', i.e., sub-pixels.

In the case where the number of unit lenses 13b corresponding to one red LED 11r' is five (i.e., odd number), a dimension of the unit lens 13b may be different according to positions. For example, a dimension of unit lenses #1 and #5 positioned at the edges of the five unit lenses may be larger than a dimension of a unit lens #3 positioned in the center. Also, a dimension of unit lenses #1 and #5 positioned at the edges of the five unit lenses may be larger than dimensions of adjacent unit lenses #2 and #4. Further, dimensions of a plurality of unit lenses #2, #3 and #4 from among the five unit lenses may be the same.

In the case where the number of unit lenses 13b corresponding to the red LED 11r' is six (i.e., even number), a dimension of the unit lens 13b may be different according to positions. For example, a dimension of unit lenses #1 and #6 positioned at the edges of the six unit lenses may be larger than dimensions of unit lenses #3 and #4 positioned in the center. Dimensions of a plurality of unit lenses #2, #3, #4 and #5 from among the six unit lenses may be the same.

In the case where a plurality of unit lenses 13b correspond to one sub pixel 11r' (e.g., red LED), a color split, which occurs when only one unit lens 13b corresponds to one sub-pixel 11r', may be reduced.

The above-described dispositions of unit lenses 13b were described taking an example of a width direction (e.g., x axis direction). However, it would be easily understood by one of ordinary skill in the art that the same may apply to a height direction (e.g., z axis direction) of the LED 11.

The description of the sub-pixels, the red LED 11r', the green LED 11g', and the blue LED 11b' corresponding to a triangle-shaped unit lens 13b of FIG. 5B will be omitted herein, since it is substantially similar (i.e., only a shape of unit lens is different) to the description of the sub-pixels, the red LED 11r, the green LED 11g, and the blue LED 11b of FIG. 5A.

Referring to FIG. 5C, an LED 11, i.e., a full pixel, may be implemented with a plurality of sub-pixels, e.g., a red LED 11r', a green LED 11g', and a blue LED 11b'.

An optical element 13 may correspond to each of the red LED 11r", the green LED 11g" and the blue LED 11b", i.e., sub-pixels, may be implemented. The red LED 11r", the green LED 11g" and the blue LED 11b" may be positioned to correspond to a triangle-shaped unit lens 13c that has round corners and is repetitively formed on the optical element 13.

A plurality of triangle-shaped unit lenses 13c having round corners may correspond to one sub-pixel 11r" (i.e., red LED).

A width I1r" of a red LED 11r" may be, for example, 300 µm. A width I2r" (or pitch) of a triangle-shaped unit lens 13c of the optical element 13 may vary according to exemplary embodiments. For example, the width I2r" may be less than or equal to 1/6 of the width I1r" of the red LED 11r". For another example, the width I2r" of the unit lens 13c may be less than or equal to 1/5 of the width I1r" of the red LED 11r". As a result, for example, the width I2r" of a unit lens 13c may be in the range of 20 µm to 50 µm.

A width I1g" of a green LED 11g" may be, as a non-limiting example, 300 µm. A width I2g" of a unit lens 13c of the optical element 13 may vary according to exemplary embodiments. For example, the width I2g" may be less than or equal to 1/6 of the width I1g" of the green LED 11g". Further, a width I2g" of a unit lens 13c may be less than or equal to 1/5 of a width I1g" of a green LED 11g". As a result, for example, the width I2g" of a unit lens 13c may be in the range of 20 µm to 50 µm.

A width I1b" of a blue LED 11b" may be, as a non-limiting example, 300 µm. A width I2b" of a unit lens 13c of the optical element 13 may vary according to exemplary embodiments. For example, the width I2b" may be less than or equal to 1/6 of the width I1b" of the blue LED 11b". For another example, the width I2b" of the unit lens 13c may be less than or equal to 1/5 of a width I1b" of the blue LED 11b". As a result, for example, the width I2b" of a unit lens 13c may be in the range of 20 µm to 50 µm.

A unit lens 13c of the optical element 13 may be repetitively formed to correspond to a dimension (e.g., width X length (height)) of an LED module 10.

A pitch between unit lenses 13c of the optical element 13 may be formed to correspond to a pitch between the sub-pixels, i.e., the red LED 11r", the green LED 11g", and the blue LED 11b". For example, a pitch between a plurality of triangle-shaped unit lenses having round corners which correspond to the red LED 11r" and a plurality of triangle-shaped unit lenses having round corners which correspond to the green LED 11g" may be formed to correspond to a pitch between the red LED 11r" and the green LED 11g". Likewise, a pitch between a plurality of triangle-shaped unit lenses having round corners which correspond to the green LED 11g" and a plurality of triangle-shaped unit lenses having round corners which correspond to the blue LED 11b" may be formed to correspond to a pitch between the green LED 11g" and the blue LED 11b". Also, a pitch between a plurality of triangle-shaped unit lenses having round corners which correspond to the blue LED 11b" and a plurality of triangle-shaped unit lenses having round corners which correspond to the red LED 11r" may be formed to correspond to a pitch between the blue LED 11b" and the red LED 11r".

According to another exemplary embodiment, a pitch between unit lenses 13c of the optical element 13 may be formed to correspond to a pitch between an LED 11, which is a full pixel, and another adjacent LED. For example, a pitch between a plurality of unit lenses corresponding to one LED 11 and a plurality of unit lenses corresponding to the next LED may be formed to correspond to a pitch between one LED 11 and a next LED positioned in a traverse direction (e.g., x-axis direction). Likewise, a pitch between a plurality of unit lenses corresponding to one LED 11 and a plurality of unit lenses corresponding to the next LED may be formed to correspond to a pitch between one LED 11 and a next LED positioned in a longitudinal direction (e.g., z axis direction).

According to another exemplary embodiment, a dimension (e.g., height, width or area) of a unit lens 13a of the optical element 13 may be formed differently according to a pitch between the red LED 11r", the green LED 11g" and the blue LED 11b", i.e., sub-pixels.

In the case where the number of unit lenses 13c corresponding to one red LED 11r" is five (i.e., odd number), a dimension of the unit lens 13c may be different according to positions. For example, a dimension of unit lenses #1 and #5 positioned at the edges of the five unit lenses may be larger than a dimension of a unit lens #3 positioned in the center. Also, a dimension of unit lenses #1 and #5 positioned at the edges of the five unit lenses may be larger than dimensions of adjacent unit lenses #2 and #4. Further, dimensions of a plurality of unit lenses #2, #3 and #4 from among the five unit lenses may be the same.

In the case where the number of unit lenses 13c corresponding to the red LED 11r' is six (i.e., even number), a dimension of the unit lens 13c may be different according to positions. For example, a dimension of unit lenses #1 and #6 positioned at the edges of the six unit lenses may be larger than dimensions of unit lenses #3, #4 positioned in the center. Dimensions of a plurality of unit lenses #2, #3, #4 and #5 from among the six unit lenses may be the same.

In the case where a plurality of unit lenses 13c correspond to one sub pixel 11r" (e.g., red LED), a color split which occurs when only one unit lens 13c corresponds to one sub-pixel 11r" may be reduced.

The above-described dispositions of unit lenses 13c were described taking an example of a width direction (e.g., x axis direction). However, it would be easily understood by one of ordinary skill in the art that the same may apply to a height direction (e.g., z axis direction) of the LED 11.

The description of the sub-pixels, the red LED 11r", the green LED 11g", and the blue LED 11b" corresponding to a triangle-shaped unit lens 13c of FIG. 5C will be omitted herein, since it is substantially similar (i.e., only a shape of unit lens is different) to the description of the sub-pixels, the red LED 11r, the green LED 11g, and the blue LED 11b of FIG. 5A

FIG. 6A illustrates a front perspective view of an LED display apparatus according to another exemplary embodiment.

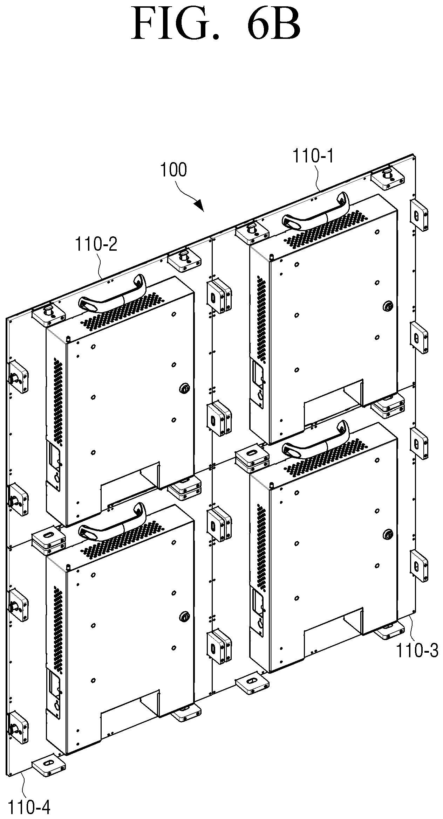

FIG. 6B illustrates a rear perspective view of an LED display apparatus according to yet another exemplary embodiment.

Referring to FIGS. 6A and 6B, an LED display apparatus 100 may include a plurality of LED panels 110 (e.g., 110-1 to 110-4). The LED panel 110 may be triangular, quadrilateral (for example, rectangle or square) or polygonal.

The plurality of LED panels 110 may be connected to each other in a matrix form (for example, M*N, in which M and N are natural numbers). The size of arrays in the matrix may be the same (e.g., 2*2 or 4*4) or different from each other. A plurality of LED panels (e.g., 110-1 to 110-4) may be connected to each other using a link bracket 124 (see FIG. 2B) and a coupling member (e.g., bolt, rivet, or etc.).

A timing controller of each of the LED panels 110-1 to 110-4 may generate video data (or image data) and a control signal corresponding to video (or image) received from an external control device, and may transmit the generated video data and control signal to each of LEDs 11 of the LED panels 110-1 to 110-4.

The LED display apparatus 100 may display content (e.g., video, image, or etc.) by driving each of the LEDs 11 of the LED panels 110-1 to 110-4.

An external control device may transmit video data and a control signal corresponding to the content to the LEDs 110-1 to 110-4. For example, the external control device may transmit video data and a control signal corresponding to the content to the LEDs 110-1 to 110-4 at one time.

The aforementioned methods according to exemplary embodiments may be implemented as a program command executable by various computer means, and the program command may be stored in a non-transitory computer-readable medium. The computer-readable medium may include a program command, a data file, a data structure, etc., taken alone or in combination. For example, the computer-readable medium may be recorded on a volatile or non-volatile storage device such as ROM, etc., or for example, a memory such as RAM, a memory chip, a device or an integrated circuit, or may be recorded optically or magnetically such as a CD, DVD, a magnetic disk or magnetic tape, etc. Simultaneously, the computer-readable medium may be stored in a storage medium readable by a machine (e.g., computer).

It would be understood that a memory that may be included in a mobile terminal is an example of a program including instructions to implement the exemplary embodiments or a storage medium that is readable using an appropriate machine. A program command recorded on the medium may be specially designed and configured for the present disclosure or may be made public to one of ordinary skill in the art of computer software.

Although some exemplary embodiments have been illustrated and described, it should be understood that the present disclosure is not limited to the disclosed embodiments and may be variously changed without departing from the the scope of the inventive concept.

Thus, the scope of the inventive concept is not limited to a specific embodiment form. Instead, modifications, equivalents and replacements included in the disclosed concept and technical scope of this description may be employed.

## Claims

1. A light emitting diode (LED) display apparatus (100) comprising:
an LED module (10) comprising a plurality of LEDs mounted on a circuit board (12); and
an optical film (13) comprising a plurality of unit lenses (13a, 13b, 13c) configured to cover the LED module and transmit light emitted from the plurality of LEDs, wherein
at least one of the plurality of unit lenses has a cross-lenticular lens shape or a cross-prismatic lens shape such that a lengthwise section and a widthwise section of the optical film have a same shape,
wherein each of the plurality of LEDs forms one sub-pixel (11r, 11g, 11b), and a plurality of sub-pixels (11r, 11g, 11b) form one pixel of a screen of the LED display apparatus (100), and
wherein the width (I2r, I2g, I2b) of each unit lens (13a, 13b, 13c) is less than the width (I1r, I1g, I1b) of the LED such that multiple unit lenses overlap one LED of the plurality of LEDs.

2. The apparatus as claimed in claim 1, wherein the one pixel is formed using a red LED (11r), a green LED (11g), and a blue LED (11b) from among the plurality of sub-pixels (11r, 11g, 11b).

3. The apparatus as claimed in any of claim 1 to claim 2, wherein a cross-sectional shape of the plurality of unit lenses (13a, 13b, 13c) comprises at least one of a triangle, a round, a triangle having round corners, and a polygonal having round corners.

4. The apparatus as claimed in claim 3, wherein at least two unit lenses from among the plurality of unit lenses (13a, 13b, 13c) have a different size of a cross-sectional shape.

5. The apparatus as claimed in claim 1, wherein a number of the unit lenses (13a, 13b, 13c) overlapping the one LED is equal to or greater than five.

6. The apparatus as claimed in any of claim 2 to claim 5, wherein a width (I2r, I2g, I2b) of a unit lens is in a range of 20 µm to 50 µm.

7. The apparatus as claimed in any of claim 1 to claim 6, wherein a raw material of the optical film (13) comprises at least one of acryl, polyethylene, polyethylene terephthalate (PET), resin, and silicone.

8. The apparatus as claimed in any of claim 1 to claim 7, wherein the optical film (13) is bonded to the LED module using an adhesive.

9. The apparatus as claimed in any of claim 1 to claim 8, wherein the optical film (13) further comprises a diffusing agent that is in a spherical shape and has a porous surface.

10. The apparatus as claimed in claim 9, wherein a diameter of the diffusing agent is smaller than a width (I2r, I2g, I2b) of a unit lens (13a, 13b, 13c) of the optical film (13).

11. The apparatus as claimed in any of claim 1 to claim 10, further comprising:
an LED panel (110) comprising a plurality of the LED modules arranged in a matrix form; and
an LED cabinet configured to support the LED panel and transfer at least one of power and a driving signal to the LED panel.

12. The apparatus according to any previous claim,
wherein the plurality of LEDs (11) are mounted on the circuit board (12) in a matrix form;
an LED panel (110) on which the plurality of LED modules (10) are arranged in a matrix form; and
the plurality of unit lenses (13a, 13b, 13c) are configured to cover the plurality of LED modules and transmit light emitted from the plurality of LEDs.

## Patentansprüche

1. Leuchtdioden(LED)-Anzeigevorrichtung (100), umfassend:
ein LED-Modul (10), das eine Vielzahl von LEDs umfasst, die auf einer Leiterplatte (12) montiert sind; und
einen optischen Film (13), der mehrere Einheitslinsen (13a, 13b, 13c) umfasst, die konfiguriert sind, um das LED-Modul abzudecken und von der Vielzahl von LEDs emittiertes Licht zu übertragen, wobei
mindestens eine der Vielzahl von Einheitslinsen eine kreuzlinsenförmige Linsenform oder eine kreuzprismatische Linsenform aufweist, so dass ein Längsschnitt und ein Breitenabschnitt des optischen Films dieselbe Form haben,
wobei jedes der Vielzahl von LEDs ein Subpixel (11r, 11g, 11b) bildet und eine Vielzahl von Subpixeln (11r, 11g, 11b) ein Pixel eines Bildschirms der LED-Anzeigevorrichtung (100) bilden und
wobei die Breite (l2r, l2g, I2b) jeder Einheitslinse (13a, 13b, 13c) geringer ist als die Breite (I1r, I1g, I1b) der LED, so dass mehrere Einheitslinsen eine LED der Vielzahl von LEDs überlappen.

2. Vorrichtung nach Anspruch 1, wobei das eine Pixel unter Verwendung einer roten LED (11r), einer grünen LED (11g) und einer blauen LED (11b) aus der Vielzahl von Subpixeln (11r, 11g, 11b) gebildet wird.

3. Vorrichtung nach einem der Ansprüche 1 bis 2, wobei eine Querschnittsform der Vielzahl von Einheitslinsen (13a, 13b, 13c) mindestens eines eines Dreiecks, einer Runde, eines Dreiecks mit runden Ecken und eines Polygons mit runden Ecken umfasst.

4. Vorrichtung nach Anspruch 3, wobei mindestens zwei Einheitslinsen aus der Vielzahl von Einheitslinsen (13a, 13b, 13c) eine unterschiedliche Größe einer Querschnittsform aufweisen.

5. Vorrichtung nach Anspruch 1, wobei eine Anzahl der Einheitslinsen (13a, 13b, 13c), die die eine LED überlappen, gleich oder größer als fünf ist.

6. Vorrichtung nach einem der Ansprüche 2 bis 5, wobei eine Breite (I2r, I2g, I2b) einer Einheitslinse in einem Bereich von 20 µm bis 50 µm liegt.

7. Vorrichtung nach einem der Ansprüche 1 bis 6, wobei ein Rohmaterial des optischen Films (13) mindestens eines aus Acryl, Polyethylen, Polyethylenterephthalat (PET), Harz und Silikon umfasst.

8. Vorrichtung nach einem der Ansprüche 1 bis 7, wobei der optische Film (13) unter Verwendung eines Klebstoffs mit dem LED-Modul verbunden ist.

9. Vorrichtung nach einem der Ansprüche 1 bis 8, wobei der optische Film (13) ferner ein Diffusionsmittel umfasst, das eine kugelförmige Form aufweist und eine poröse Oberfläche aufweist.

10. Vorrichtung nach Anspruch 9, wobei ein Durchmesser des Diffusionsmittels kleiner als eine Breite (12r, 12g, 12b) einer Einheitslinse (13a, 13b, 13c) des optischen Films (13) ist.

11. Vorrichtung nach einem der Ansprüche 1 bis 10, ferner umfassend:
ein LED-Panel (110), das eine Vielzahl von in einer Matrixform angeordneten LED-Modulen umfasst; und
ein LED-Gehäuse, das konfiguriert ist, um das LED-Panel zu unterstützen und mindestens eines von Strom- und einem Ansteuersignal an das LED-Panel zu übertragen.

12. Vorrichtung gemäß einem der vorherigen Ansprüchen,
wobei die Vielzahl von LEDs (11) in einer Matrixform auf der Leiterplatte (12) montiert sind; ein LED-Panel (110), auf dem eine Vielzahl von LED-Modulen (10) in einer Matrixform angeordnet sind; und
die Vielzahl von Einheitslinsen (13a, 13b, 13c) konfiguriert sind, um die Vielzahl von LED-Modulen abzudecken und von der Vielzahl von LEDs emittiertes Licht durchzulassen.

## Revendications

1. Dispositif d'affichage (100) à diode électroluminescente (DEL) comprenant :
un module DEL (10) comprenant une pluralité de DEL montées sur une carte de circuit imprimé (12) ; et
un film optique (13) comprenant une pluralité de lentilles unitaires (13a, 13b, 13c) configurées pour recouvrir le module DEL et transmettre la lumière émise par la pluralité de DEL, dans lequel
au moins une de la pluralité de lentilles unitaires a une forme de lentille lenticulaire transversale ou une forme de lentille prismatique transversale de sorte qu'une section longitudinale et une section transversale du film optique ont une même forme,
dans lequel chacune de la pluralité de DEL forme un sous-pixel (11r, 11g, 11b), et une pluralité de sous-pixels (1r, 11g, 11b) forment un pixel d'un écran du dispositif d'affichage à DEL (100), et
dans lequel la largeur (l2r, l2g, l2b) de chaque lentille unitaire (13a, 13b, 13c) est inférieure à la largeur (11r, 11g, 11b) de la DEL de sorte que plusieurs lentilles unitaires chevauchent une DEL de la pluralité de DEL.

2. Dispositif selon la revendication 1, dans lequel le pixel est formé en utilisant une DEL rouge (11r), une DEL verte (11g) et une DEL bleue (11b) parmi la pluralité de sous-pixels (11r, 11g, 11b).

3. Dispositif selon l'une quelconque de la revendication 1 et de la revendication 2, dans lequel une forme en coupe transversale de la pluralité de lentilles unitaires (13a, 13b, 13c) comprend au moins l'un parmi un triangle, un rond, un triangle ayant des coins arrondis et un polygone ayant des coins arrondis.

4. Dispositif selon la revendication 3, dans lequel au moins deux lentilles unitaires parmi la pluralité de lentilles unitaires (13a, 13b, 13c) ont une taille différente d'une forme en coupe transversale.

5. Dispositif selon la revendication 1, dans lequel un nombre des lentilles unitaires (13a, 13b, 13c) chevauchant la DEL est égal ou supérieur à cinq.

6. Dispositif selon l'une quelconque des revendications 2 à 5, dans lequel une largeur (l2r, l2g, l2b) d'une lentille unitaire est dans une plage de 20 µm à 50 µm.

7. Dispositif selon l'une quelconque des revendications 1 à 6, dans lequel une matière première du film optique (13) comprend au moins l'un parmi l'acrylique, le polyéthylène, le polyéthylène téréphtalate (PET), la résine et la silicone.

8. Dispositif selon l'une quelconque des revendications 1 à 7, dans lequel le film optique (13) est lié au module DEL en utilisant un adhésif.

9. Dispositif selon l'une quelconque de la revendication 1 à à la revendication 8, dans lequel le film optique (13) comprend en outre un agent de diffusion qui a une forme sphérique et a une surface poreuse.

10. Dispositif selon la revendication 9, dans lequel un diamètre de l'agent de diffusion est inférieur à une largeur (l2r, l2g, l2b) d'une lentille unitaire (13a, 13b, 13c) du film optique (13).

11. Dispositif selon l'une quelconque de la revendication 1 à la revendication 10, comprenant en outre :
un panneau DEL (110) comprenant une pluralité des modules DEL agencés sous une forme matricielle ; et
une armoire à DEL configurée pour supporter le panneau DEL et transférer au moins l'un parmi une alimentation et un signal de commande au panneau DEL.

12. Dispositif selon une quelconque revendication précédente,
dans lequel la pluralité de DEL (11) sont montées sur la carte de circuit imprimé (12) sous une forme matricielle ;
un panneau DEL (110) sur lequel la pluralité de modules DEL (10) sont agencés sous une forme matricielle ; et
la pluralité de lentilles unitaires (13a, 13b, 13c) sont configurées pour recouvrir la pluralité de modules DEL et transmettre la lumière émise par la pluralité de DEL.
